(19) Europäisches Patentamt
European Patent Office
Office européen des brevets

(11) **EP 4 708 695 A1**

(12) **EUROPEAN PATENT APPLICATION**

(43) Date of publication:
**11.03.2026 Bulletin 2026/11**

(21) Application number: **24219417.3**

(22) Date of filing: **12.12.2024**

(51) International Patent Classification (IPC):
***H03K 19/0185*** (2006.01)  ***H03K 19/094*** (2006.01)

(52) Cooperative Patent Classification (CPC):
**H03K 19/018514; H03K 19/09432**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.09.2024  IN 202441068423**

(71) Applicant: **Samsung Electronics Co., Ltd.**
**Suwon-si, Gyeonggi-do 16677 (KR)**

(72) Inventors:
• **DATTA, Subhadeep**
**560048 Bengaluru (IN)**
• **DAS, Tamal**
**560048 Bengaluru (IN)**

(74) Representative: **Marks & Clerk LLP**
**15 Fetter Lane**
**London EC4A 1BW (GB)**

(54) **SKEW CONTROL CIRCUIT FOR A HIGH-SPEED CLOCK DISTRIBUTION NETWORK AND METHOD FOR OPERATING THE SAME**

(57)    A skew control circuit (600) is provided. The skew control circuit (600) includes at least one current-mode logic, CML, buffer, and an inductor-capacitor, LC, tank connected in series with a tail current source of the at least one CML buffer (601, 604). The at least one CML buffer (601, 604) filters a skew between complementary input clocks to a high-speed clock distribution network.

FIG. 6

EP 4 708 695 A1

## Description

BACKGROUND

The disclosure relates to a skew control circuit and a method for operating the same, and more particularly, to a skew control circuit for high-speed clock distribution networks running in several gigahertz (GHz).

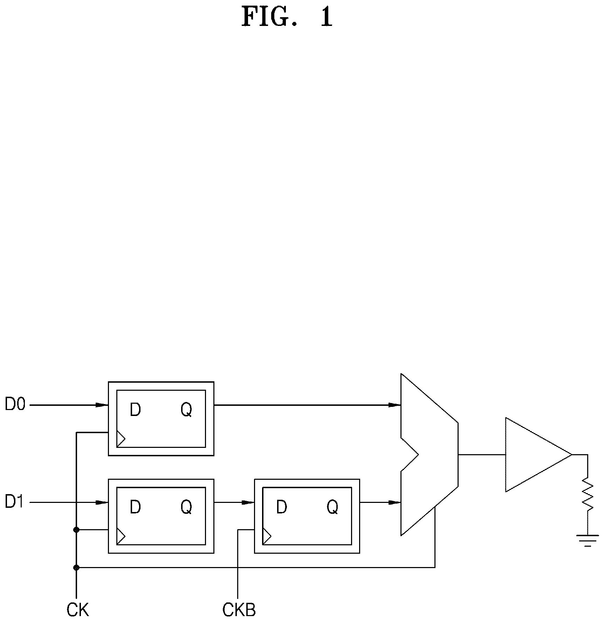

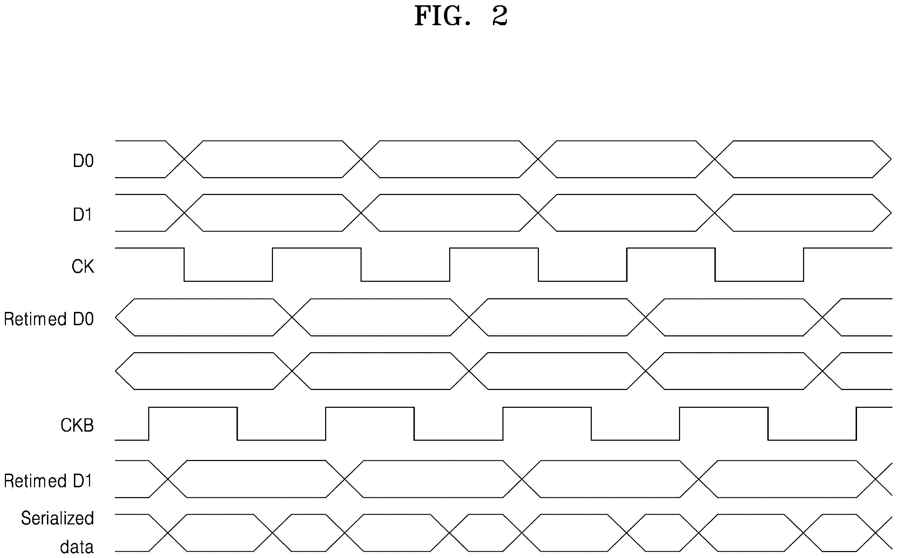

Recently, clock skew has become an important factor in in high-speed, high-performance serial link designs. In an example scenario, a skew between differential clock pair, clock (CK) and clock bar (CKB) in a final 2:1 multiplexer of a wireline transmitter, translates to jitter in the final serialized output. FIG. 1 illustrates a final 2:1 multiplexer of a wireline transmitter data path according to a comparative example. The final 2:1 multiplexer in a high-speed serial link/SerDes PHY aligns the even and odd data based on a half-rate clock (CK). Although the final 2:1 multiplexer may help avoid the duty cycle problem, the multiplexer design poses a challenge in terms of bandwidth limitation for very-high speed operations. This issue may be addressed or mitigated using different circuit techniques or by using a quarter-rate transmitter architecture. For example, as shown in FIG. 2, even data may be sampled by rising edges of CK and odd data may be sampled by rising edges of CKB. If a skew exists between CK and CKB, then that skew will translate to the exact same amount of jitter at the final serialized data of the wireline transmitter. For example, a $\pm2ps$ skew can eat up to 5% of the unit interval (UI) which is extremely costly for high speed serial link designs. Here, D0 and D1 may refer to odd and even data respectively. For an N-Gbps high-speed serial link's final 2:1 multiplexer (shown in FIG. 1), each of D0 and D1 are N/2 Gbps data. Retiming D0 and D1 (e.g., retimed D0 and retimed D1) using the set of 3 flip-flops and a 2:1 multiplexer, as shown in FIG. 1, is done to serialize the data and send an N-Gbps data stream into the channel.

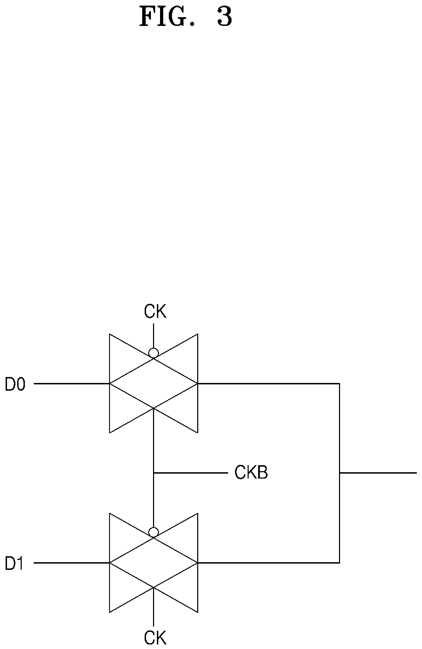

Multiplexers are widely used in serial link designs. A skew between CK and CKB may cause contention between the odd and the even data stream, causing jitters at the multiplexer output. FIG. 3 shows a basic implementation of a 2:1 MUX which is widely used in wireline transceivers. If CK and CKB has a skew, then there will be a certain portion of the clock period where both CK and CKB are high. In this window, both the passgates will be transparent, and as such, there will be a contention between the even data and the odd data streams leading to jitter at the output of the 2:1 MUX.

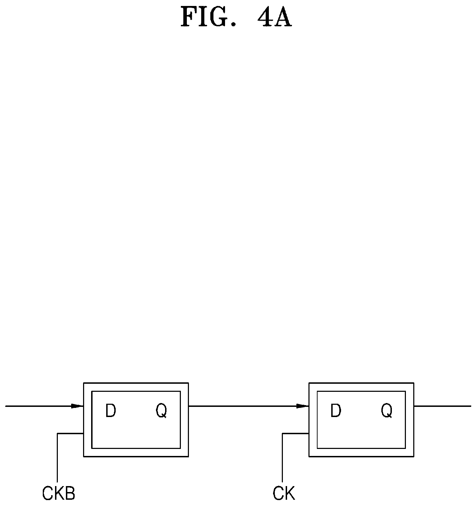

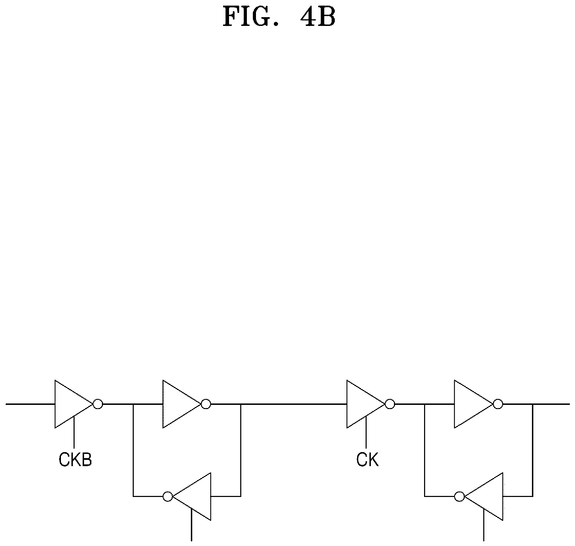

In another scenario, skew between CK and CKB in a flip-flop may cause jitter at the output, which may further lead to a timing failure. FIGS. 4A and 4B illustrate a master-slave latch based flip-flop implementation. When CK goes high, the slave latch is supposed to output the data that was sampled when CKB was high previously. Due to the presence of skew between the differential input clocks, CK and CKB have an overlap and both are high together, making both latches transparent. In this window, if the data is transitioning at the input, then this will lead to jitter at the flip-flop output, which could lead to hold timing violation(s) in the subsequent sequential logic element, which is a functional failure. The setup time of the flip-flop is equal to the delay of the two forward path inverters of the master latch. If there is a skew between CK and CKB in such way that CKB is delayed, then this skew will increase the effective setup time of the flip-flop, which might lead to timing failure in slow, low-voltage set of PVT conditions.

In another scenario, in a half-rate architecture of wireline receivers, a skew between CK and CKB may cause jitter when the cursors are generated using the complementary clocks to sample the data stream at the center of each UI.

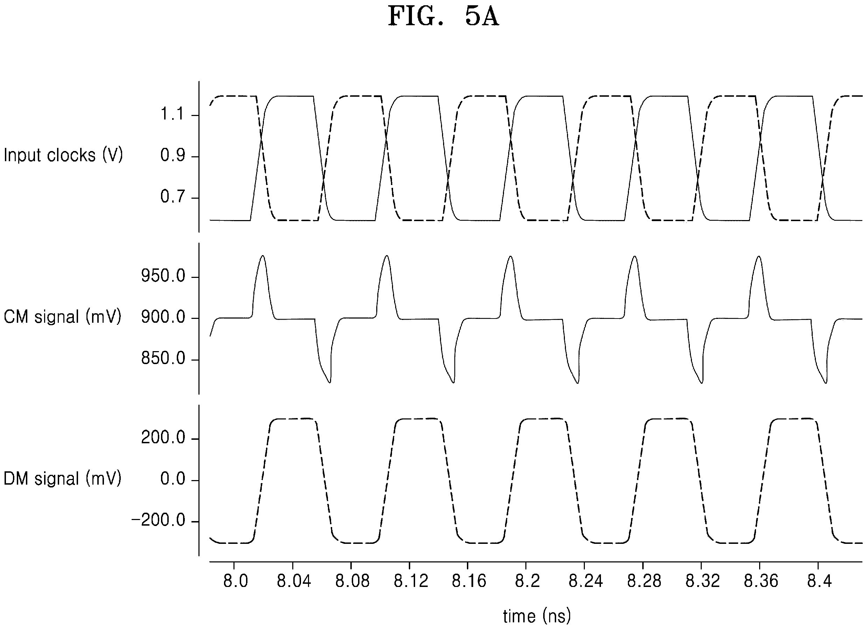

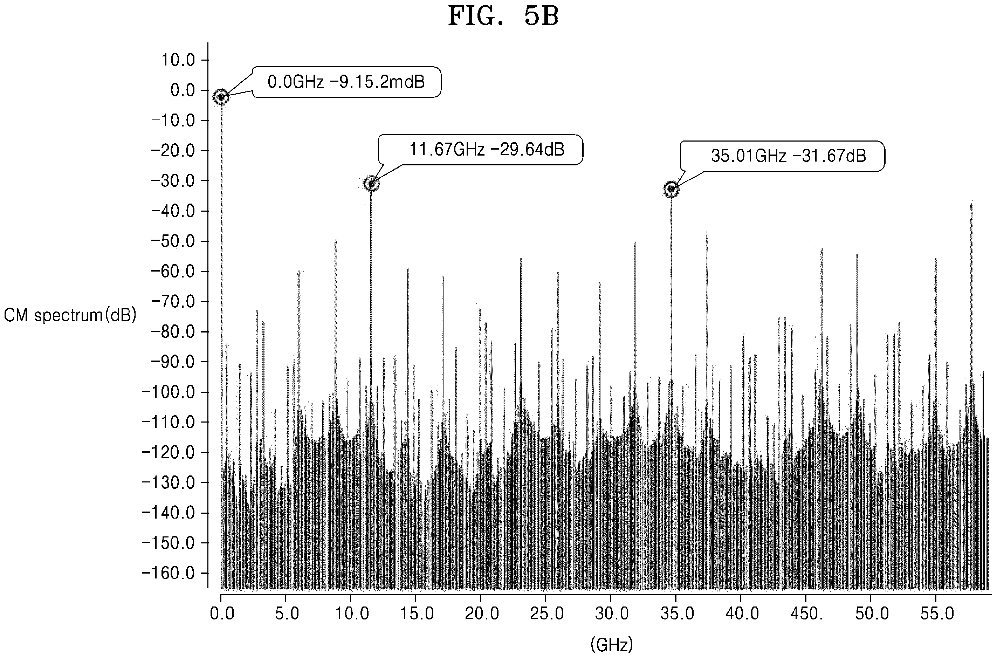

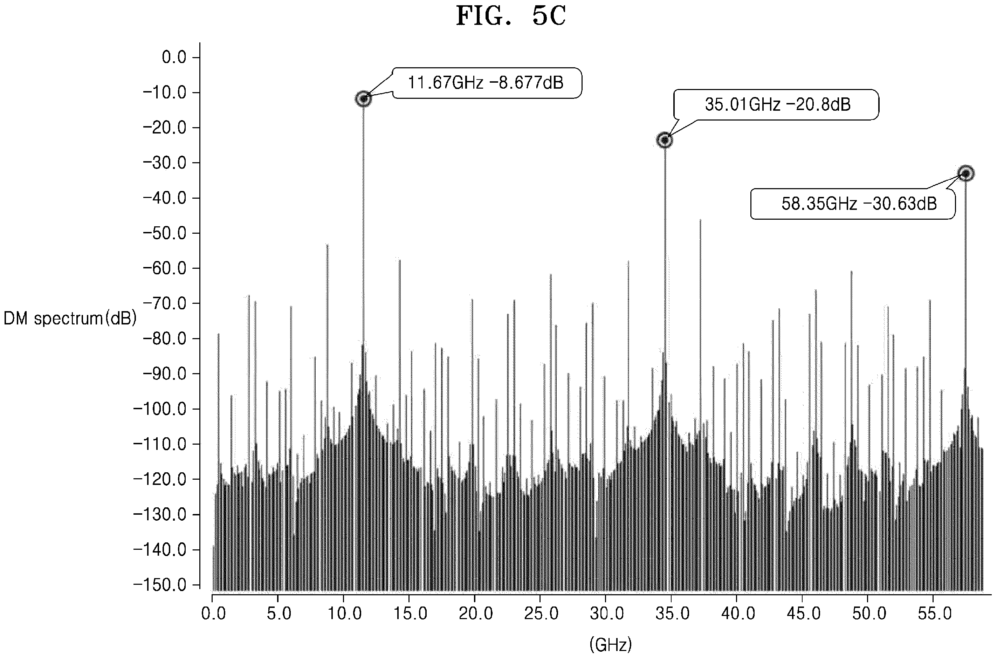

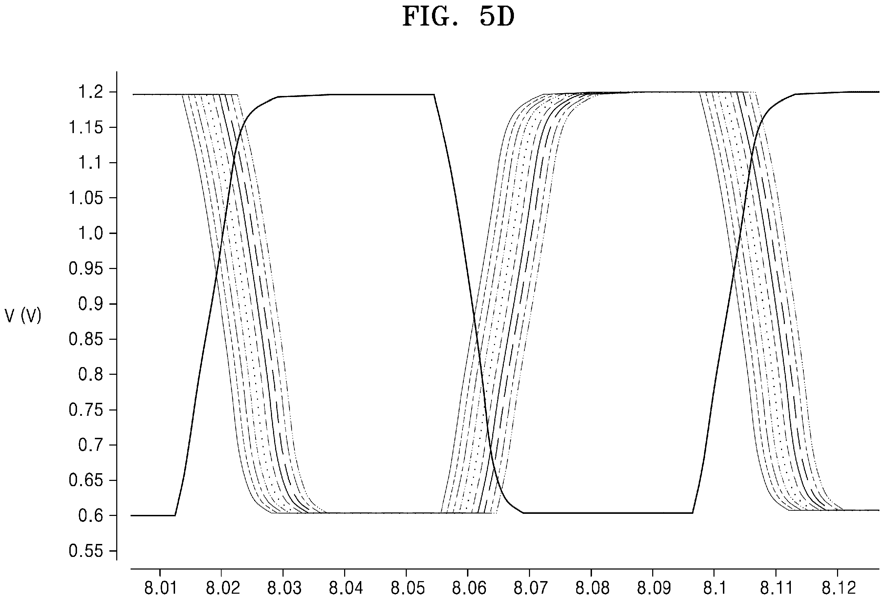

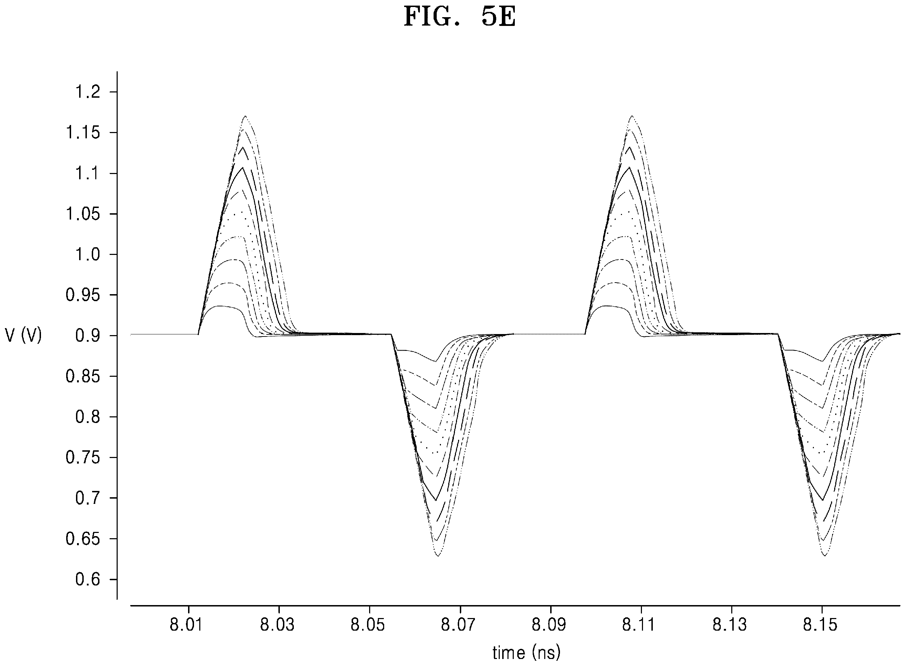

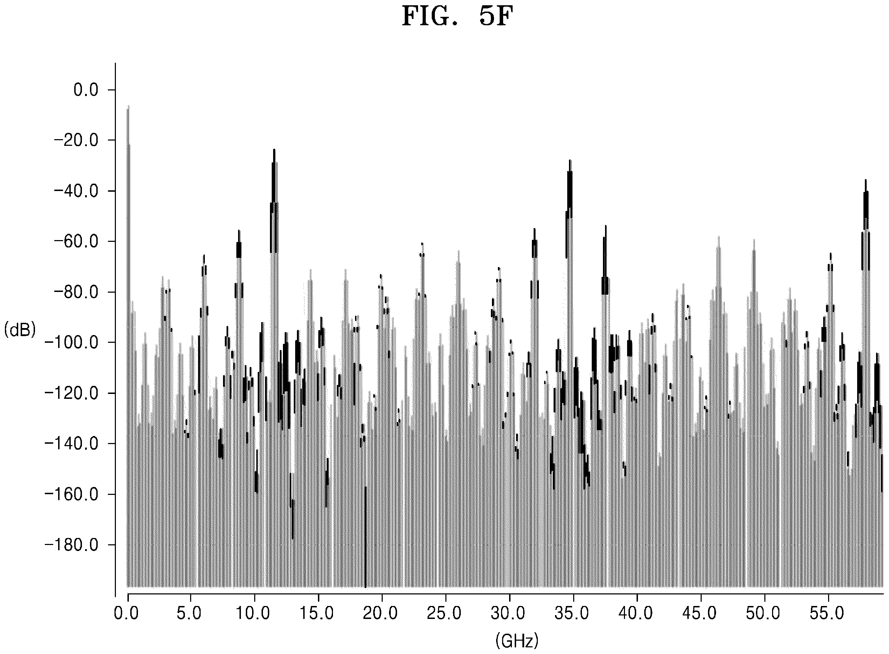

FIGS. 5A-5F illustrate example waveforms showing skews in the frequency domain. FIG. 5A illustrates example waveforms showing the broken down skew in terms of the common-mode (CM) and differential-mode (DM) signals of the input differential clocks. FIG. 5B illustrates an example spectrum of the CM signal. FIG. 5C illustrates an example spectrum of the DM signal. FIG. 5D illustrates examples of different skews between CK and CKB. FIG. 5D illustrates an output of the differential clock pair, one clock is fixed and the skew with respect to it is varied in its complementary clock which generates gradual relative shifts in time as if the other clock starts slowly starts moving away from it. FIG. 5E illustrates an example of CM components of the aforesaid skews wherein higher skew translates to higher amplitude. FIG. 5E indicates a common-mode of the same set of differential clocks are plotted, with gradually increasing skew. The higher skew leads to higher strength in common-mode signal in time-domain which is depicted in the figure. FIG. 5F illustrates example spectrums of the CM components, which holds the same aforesaid relation, i.e., higher skew translates to higher strength of CM in frequency domain. FIG. 5F indicates the spectrum of the same set of differential clocks are plotted with gradually increasing skew. The higher skew leads to higher strength in the odd harmonics in the spectrum of the common-mode signals.

Hence, clock distribution networks of high-performance, high-speed serial links need to have a mechanism to tackle and minimize the skew between differential clock pair which are used in most of the basic building blocks of the wireline transceiver.

SUMMARY

One or more aspects of the disclosure provide a skew control circuit for a high-speed clock distribution network that minimizes skew between differential clock pair.

One or more aspects of the disclosure provide a method for controlling skew between complementary input clocks of a high speed clock distribution network.

According to an aspect of the disclosure, there is provided a skew control circuit including: at least one current-mode logic (CML) buffer; and an inductor-capacitor (LC) tank connected in series with a tail current source of the at least one CML buffer, wherein the at least one CML buffer is configured to filter a skew between complementary input clocks to a high-speed clock distribution network.

According to an embodiment there is provided a skew control circuit comprising at least one (CML) buffer; and an LC tank connected in series with a tail current source of the at least one CML buffer. The at least one CML buffer may be configured to filter a skew between complementary input clocks to output filtered complementary clocks. The filtered complementary clocks may be output to a clock distribution network (e.g. a high-speed clock distribution network).

The skew control circuit may comprise one or more CML buffers. Each CML buffer may have a corresponding LC tank. Each LC tank may be configured to suppress (or filter) a corresponding odd harmonic from the complementary input clocks.

According to another aspect of the disclosure, there is provided a method for controlling skew, the method including: determining, by a current-mode logic (CML) buffer, a common-mode frequency response of a complementary input clocks of a high speed clock distribution network; and controlling, by the CML buffer, the skew between the complementary input clocks of the high speed clock distribution network based on strength of the $(2n\text{-}1)^{th}$ odd harmonics in the determined common mode frequency response.

The $(2n\text{-}1)^{th}$ odd harmonics may be odd harmonics up until a $(2\text{-}1)^{th}$ odd harmonic, where n is a natural number. For instance, the $(2n\text{-}1)^{th}$ odd harmonics may be the $1^{st}$ to the $(2n\text{-}1)^{th}$ odd harmonic. For instance, n may be a number of CML buffers connected in series and used to control the skew. Each CML buffer may be connected to a corresponding LC circuit which is configured to filter out a corresponding one of the odd harmonics.

According to an embodiment there is provided a method for controlling skew, the method including: determining, by a current-mode logic (CML) buffer, a common-mode frequency response of a complementary input clocks of a high speed clock distribution network; and controlling, by the CML buffer, the skew between the complementary input clocks of the high speed clock distribution network based on strength of the $(2n\text{-}1)^{th}$ odd harmonic in the determined common mode frequency response. n may be a natural number. For instance, n may be a number of CML buffers.

According to an embodiment there is provided a method for controlling skew, the method including: determining, by a current-mode logic (CML) buffer, a common-mode frequency response of a complementary input clocks of a high speed clock distribution network; and controlling, by the CML buffer, the skew between the complementary input clocks of the high speed clock distribution network based on strength of the $1^{st}$ to $(2n\text{-}1)^{th}$ odd harmonics in the determined common mode frequency response. n may be a natural number. For instance, n may be a number of CML buffers.

According to an embodiment there is provided a method for controlling skew, the method including: determining, by a current-mode logic (CML) buffer, a common-mode frequency response of a complementary input clocks of a high speed clock distribution network; and controlling, by the CML buffer, the skew between the complementary input clocks of the high speed clock distribution network based on strength of n odd harmonics in the determined common mode frequency response. n may be a natural number. For instance, n may be a number of CML buffers.

At least some of the above and other features of the invention are set out in the claims. These and other aspects of the embodiments herein will be better appreciated and understood when considered in conjunction with the following description and the accompanying drawings. It should be understood, however, that the following descriptions, while indicating at least one embodiment and numerous specific details thereof, are given by way of illustration and not of limitation. Many changes and modifications may be made within the scope of the embodiments herein without departing from the scope thereof, and the embodiments herein include all such modifications.

BRIEF DESCRIPTION OF DRAWINGS

The above and other aspects, features, and advantages of certain embodiments of the disclosure will be more apparent from the following description taken in conjunction with the accompanying drawings, in which:

FIG. 1 illustrates a final 2:1 multiplexer of a wireline transmitter data path according to a comparative example;
FIG. 2 illustrates a timing diagram of a final 2:1 multiplexer of a wireline transmitter data path with CK to CKB skew according to a comparative example;
FIG. 3 shows a basic implementation of a 2:1 MUX, according to a comparative example;
FIGS. 4A and 4B a master-slave latch based flip-flop implementation;
FIGS. 5A-5F illustrate example waveforms showing skews in the frequency domain;
FIG. 6 illustrates a skew control circuit for a high-speed clock distribution network, according to embodiments;
FIGS. 7A, 7B, and 7C illustrate a high-speed serial link/SerDes PHY, according to embodiments; and
FIG. 8 illustrates a method for controlling skew between complementary input clocks of the high speed clock distribution network, according to embodiments as disclosed herein.

## DETAILED DESCRIPTION

The embodiments herein and the various features and advantageous details thereof are explained more fully with reference to the non-limiting embodiments that are illustrated in the accompanying drawings and detailed in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

For the purposes of interpreting this specification, the definitions (as defined herein) will apply and whenever appropriate the terms used in singular will also include the plural and vice versa. It is to be understood that the terminology used herein is for the purposes of describing particular embodiments only and is not intended to be limiting. The terms "comprising", "having" and "including" are to be construed as open-ended terms unless otherwise noted.

The words/phrases "exemplary", "example", "illustration", "in an instance", "and the like", "and so on", "etc.", "etcetera", "e.g.," , "i.e.," are merely used herein to mean "serving as an example, instance, or illustration." Any embodiment or implementation of the present subject matter described herein using the words/phrases "exemplary", "example", "illustration", "in an instance", "and the like", "and so on", "etc.", "etcetera", "e.g.," , "i.e.," is not necessarily to be construed as preferred or advantageous over other embodiments.

Embodiments herein may be described and illustrated in terms of blocks which carry out a described function or functions. These blocks, which may be referred to herein as managers, units, modules, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure.

It should be noted that elements in the drawings are illustrated for the purposes of this description and ease of understanding and may not have necessarily been drawn to scale. For example, the flowcharts/sequence diagrams illustrate the method in terms of the operations required for understanding of aspects of the embodiments of the disclosure. Furthermore, in terms of the construction of the device, one or more components of the device may have been represented in the drawings by conventional symbols, and the drawings may show only those specific details that are pertinent to understanding the present embodiments so as not to obscure the drawings with details that will be readily apparent to those of ordinary skill in the art having the benefit of the description herein. Furthermore, in terms of the system, one or more components/modules which include the system may have been represented in the drawings by conventional symbols, and the drawings may show only those specific details that are pertinent to understanding the present embodiments so as not to obscure the drawings with details that will be readily apparent to those of ordinary skill in the art having the benefit of the description herein.

The accompanying drawings are used to help easily understand various technical features and it should be understood that the embodiments presented herein are not limited by the accompanying drawings. As such, the disclosure should be construed to extend to any modifications, equivalents, and substitutes in addition to those which are particularly set out in the accompanying drawings and the corresponding description. Usage of words such as first, second, third etc., to describe components/elements/operations is for the purposes of this description and should not be construed as sequential ordering/placement/occurrence unless specified otherwise.

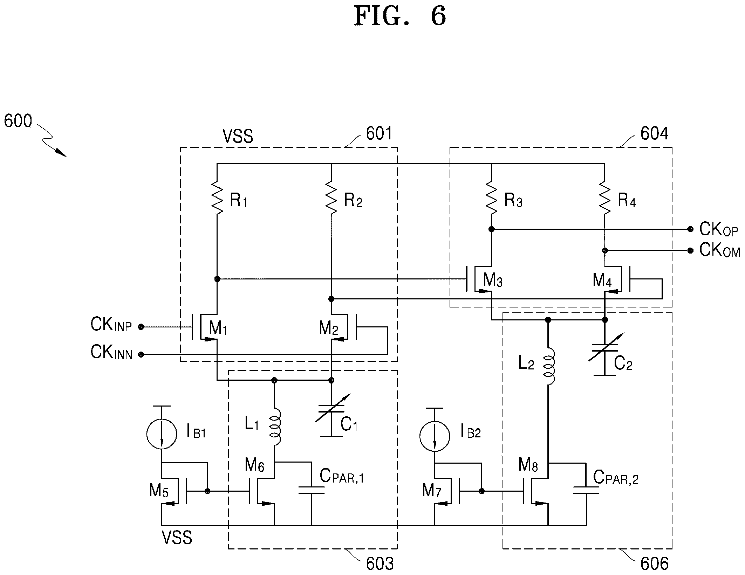

The embodiments herein achieve a skew control circuit for a high-speed clock distribution network. Referring now to the drawings, and more particularly to FIGS. 6 through 8, where similar reference characters denote corresponding features consistently throughout the figures, there are shown embodiments.

According to one or more embodiments, a skew control circuit is provided for a clock distribution network (e.g. a high-speed clock distribution network). The high-speed clock distribution network may include a plurality of cascaded Current-Mode Logic (CML) buffers. Each of the CML buffers may include an inductor-capacitor LC tank in a tail current source path. Each LC tank may be connected in series with a tail current source. The LC tank circuit may also be referred to as LC resonant circuit. The CML buffer is configured to achieve tail-resonance filtering by filtering out skew between input clocks to the high-speed clock distribution network. Each of the CML buffers may include a tail-current source with the LC tank. According to an embodiment, the skew control circuit may filter out skew between input clocks to the high-speed clock distribution network by suppressing odd harmonics of a common-mode of the input clocks to the high-speed clock distribution network. The LC tank of an $n^{th}$ CML buffer is tuned to resonate at the $(2n-1)^{th}$ harmonic of the input clocks, and the capacitor C of the LC tank is a course-tuning capacitor bank. A value of a first capacitor C of a first LC tank in a first CML buffer is tuned to have the same calibration as a phase-locked loop inductor-capacitor voltage controlled oscillator (PLL LC-VCO) driving the high-speed clock distribution network. The capacitors Cs of LC tanks in subsequent CML buffers are scaled from the value of the first capacitor C of the first LC tank in the first CML buffer, and therefore, the skew control circuits according to various embodiments herein do not require a separate calibration engine, thereby saving area, power, and design complexity. Whilst the embodiments herein discuss a "high-speed" clock distribution network, it will be appreciated that these embodiments may be equally applied to any clock distribution network. "high speed" in the context of clock signals may refer to any clock signal having a frequency that is greater than or equal to 100 MHz. Accordingly, a "high-speed" clock distribution network may be configured to operate at clock frequencies of 100 MHz or higher. Even more specifically, "high-speed" may be clock frequencies of 1GHz or higher. In one embodiment, the high-speed clock distribution circuit is configured to operate at clock frequencies of 1 GHz or higher.

FIG. 6 illustrates a skew control circuit 600 for a high-speed clock distribution network. According to an embodiment, the skew control circuit 600 may include a first CML buffer 601, a second CML buffer 604, a first filter 603 and a second filter 606. However, the disclosure is not limited thereto, and as such, according to another embodiment, the skew control circuit 600 may include one or more other components.

According to an embodiment, the first CML buffer 601 may include a first transistor $M_1$, a second transistor $M_2$, a first resistor $R_1$ and a second resistor $R_2$. For example the first transistor $M_1$ and the second transistor $M_2$ may form an input transconductor pair for a first CML buffer 601, and the first $R_1$ and the second $R_2$ may form a load resistor pair of the first CML buffer 601. Moreover, a fifth transistor $M_5$ and a sixth transistor $M_6$ may form a diode and current mirror pair for the first CML buffer 601. The current mirror may output first current $I_{B1}$. A tail current source may provide a tail current to the first CML buffer 601 (e.g. to a tail node of the first CML buffer 601). For instance, the current mirror may provide the tail current $I_{B1}$. Consider that $R_S$ is a small signal output impedance of the tail current source, then a small signal common-mode gain of a CML gain stage can be written as

$$\frac{g_{m_{1,2}} R_{1,2}}{1 + 2g_{m_{1,2}} R_s}$$

which can further be approximated as

$$\frac{R_{1,2}}{2R_S}$$

Here, $g_{m_{1,2}}$ is the small-signal trans-conductance of the input transistor pair and $R_{1,2}$ is the effective load resistance (e.g. combined resistance) of the first and second resistors $R_1$ and $R_2$.

Consider that the small signal output impedance of a tail current source is boosted by introducing a first stage resonator (i.e., a first stage LC tank). The first stage LC tank may include a first inductor $L_1$, and a first capacitor $C_1$. The first stage LC tank may be tuned to resonate with a resonance frequency of $\frac{1}{2\pi\sqrt{L_1 C_1}}$ at the first harmonic of the input clock signal ( $f_{CK} \approx \frac{1}{2\pi\sqrt{L_1 C_1}}$ ), then a blocking common-mode response can be obtained at and around a first harmonic of the clock signal.

According to an embodiment, the first filter 603 may include the sixth transistor $M_6$, the first inductor $L_1$, the first $C_1$, and a first parasitic capacitor $C_{PAR,1}$. For example, the sixth $M_6$, the first inductor $L_1$, the first capacitor $C_1$, and the first parasitic capacitor $C_{PAR,1}$ may form a first filter 603. The first filter 603 may be configured to or designed to filter out the first harmonic of the input differential clocks in their common mode (e.g., the skew between the input differential clocks).

The first capacitor $C_1$ and the first inductor $L_1$ may be connected to respective terminals of the first transistor $M_1$ and the second transistor $M_2$ (e.g. a tail node of the first CML buffer 601). The first capacitor $C_1$ and the first inductor $L_1$ may be connected in parallel to each other. The first inductor $L_1$ may be connected to the sixth transistor $M_6$ and the first parasitic capacitor $C_{PAR,1}$. The sixth transistor $M_6$ and the first parasitic capacitor $C_{PAR,1}$ may be connected in parallel to each other.

According to an embodiment, the first capacitor $C_1$ may be a capacitor bank configured to be tuned to a particular capacitance. For instance, the first capacitor $C_1$ may be a course-tuning capacitor bank. For example, the capacitor bank (e.g. the course-tuning capacitor bank) may support multiple clock frequencies used in the clock distribution network in certain applications. The first capacitor $C_1$ may be used to tune the first tail resonator to multiple frequencies. According to an embodiment, a capacitance value of the first capacitor $C_1$ may be configured to or tuned to have a same calibration as a Phase-Locked Loop Inductor-Capacitor Voltage Controlled Oscillator (PLL LC-VCO) driving the high-speed clock distribution network.

According to an embodiment, the tail node (i.e., the sources of the first transistor $M_1$ and the second transistor $M_2$) may behave like a small-signal ground in differential mode of operation of the first CML buffer 601. This leads to the boosted small-signal impedance of the tail current source path having almost no role to play in the small-signal differential response of the first CML buffer 601.

Once the first CML buffer 601 processes the clock signal by significantly attenuating the common-mode first harmonic using the first filter 603, the clock signal passes through a second CML buffer 604. The second CML buffer 604 can perform the same operations as the first CML buffer 601. According to embodiment, the second CML buffer 604 may perform operations for attenuating the common-mode third harmonic using the same idea of the tail resonance using a second filter 606. The second CML buffer 604 may include a third transistor $M_3$, a fourth transistor $M_4$, a third resistor $R_3$ and a fourth resistor $R_4$. For example, the third transistor $M_3$, and the fourth transistor $M_4$ may form an input transconductor pair for the second CML buffer 604. The third $R_3$, and the fourth $R_4$ may form the load resistor pair of the second CML buffer 604. According to an embodiment, a seventh transistor $M_7$, and an eight transistor $M_8$ may form the diode and current mirror pair for the second CML buffer 604. The current mirror may output second current $I_{B2}$. The second CML buffer 604 may have the same (or similar) design as the first CML buffer 601. A second stage LC tank 606 may be provided, having the same (or similar) design as the first stage LC tank 603. Whilst these circuits may have similar designs, the components may have different characteristics (e.g. different capacitances, resistances, etc.).

Consider that the second stage LC tank 606 (which may include a second inductor $L_2$, and a second capacitor $C_2$) is tuned to resonate at the third harmonic of the input clock signal ($f_{CK} \approx \frac{1}{6\pi\sqrt{L_1 C_1}}$). This is how a blocking common-mode response can be produced at and around the third harmonic of the clock signal.

According to an embodiment, the second capacitor $C_2$ can be a capacitor bank (e.g. a course-tuning capacitor bank). The capacitor bank (e.g. course tuning course-tuning) may support multiple clock frequencies used in the clock distribution network in certain applications. The second capacitor $C_2$ may be used to tune the second tail resonator to multiple frequencies. According to an embodiment, the capacitance value of $C_2$ may be scaled from the capacitance value of the first capacitor $C_1$. For example, the capacitance value of the second capacitor $C_2$ may be equal to nine times the capacitance value of the first capacitor for the resonant frequency of the second CML buffer 604 to be three times higher than that of the first CML buffer 601. Here, the inductance L-value of the first inductor L1 and the second inductor L2 may be kept the same.

According to an embodiment, the second filter 606 may include the eighth transistor $M_8$, the second inductor $L_2$, the second capacitor $C_2$, and a second parasitic capacitor $C_{PAR,2}$. For example, the eighth transistor $M_8$, the second inductor $L_2$, the second capacitor $C_2$, and the second parasitic capacitor $C_{PAR,2}$ may form a second filter 606. The second filter 606 may filter out the third harmonic of the clock signal (i.e., the skew).

The capacitor C2 may be tuned in a similar manner to $C_1$, based on a scaling factor. According to an embodiment, n CML buffers are provided to filter out different odd harmonics of the CM signal as mentioned earlier. Each CML buffer may be configured to filter out a corresponding $(2s-1)^{th}$ harmonic, where s is the number or position of the buffer (the stage of the buffer) in the series. In this case, the capacitors Cs of each of CML buffer s (s being an integer) may be tuned in a similar manner to $C_1$, based on a scaling factor. According to an embodiment, the transistors illustrated in FIG. 6 may be a MOSFET, such as an NMOS transistor or a PMOS transistor. However, the disclosure is not limited thereto, and as such, other types of transistors or switches may be provided. According to an embodiment, CKINP/CKINN are differential clock inputs with skew, which is filtered out by the skew control circuit 600, and CKOP and CKOM are adjusted or modified clock outputs. In some cases, CKOP and CKOM may be referend to as clean outputs. For example, CKOP and CKOM may be considered as output with skew removed or mitigated.

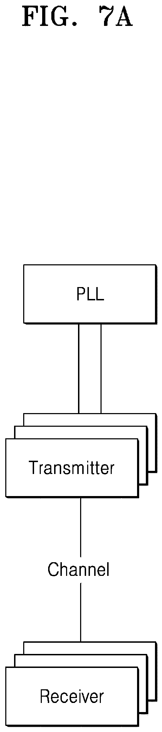

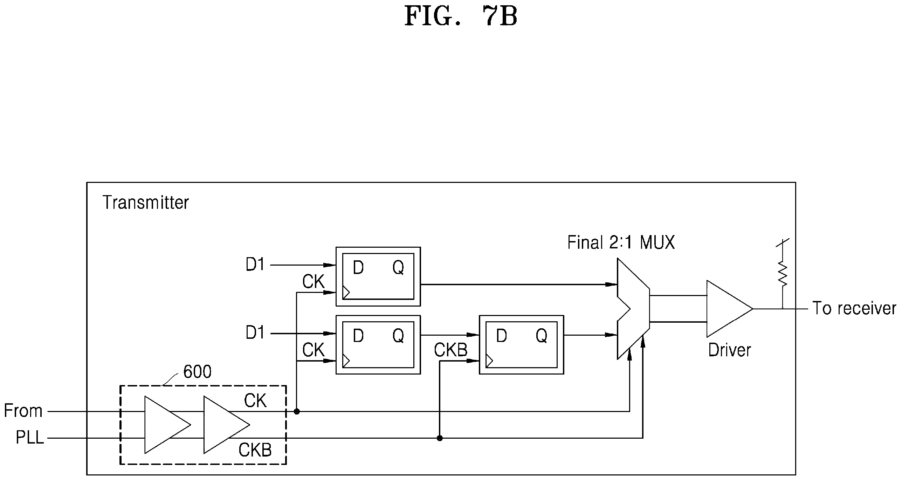

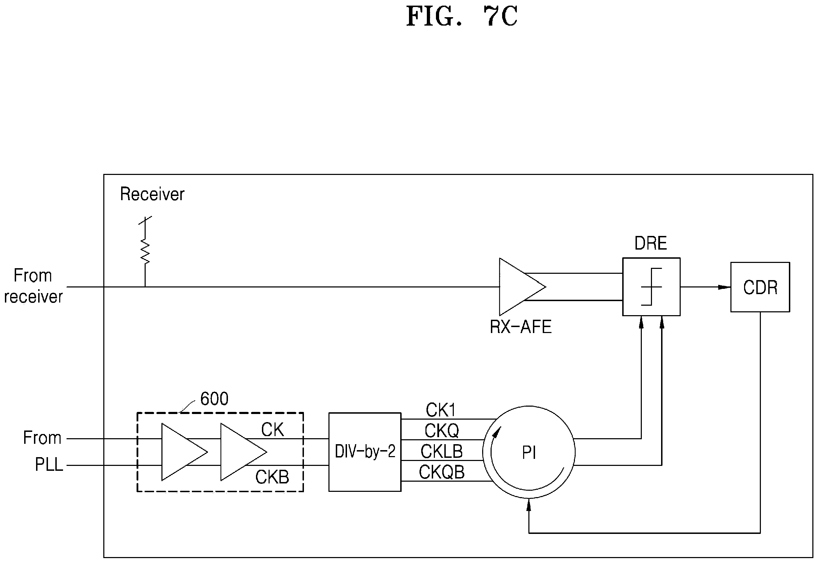

FIGS. 7A, 7B, and 7C illustrate a high-speed serial link/SerDes PHY. FIG. 7A illustrates a high-speed serial link/SerDes PHY. FIG. 7B illustrates a transmitter of the high-speed serial link/SerDes PHY. According to an embodiment, the skew control circuit 600 as illustrated in FIG. 6 may be applied to the transmitter of the high-speed serial link/SerDes PHY. FIG. 7C illustrates a receiver of the high-speed serial link/SerDes PHY. According to an embodiment, the skew control circuit 600 as illustrated in FIG. 6 may be applied to the receiver of the high-speed serial link/SerDes PHY. Referring to FIG. 7B and 7C, the clock CK and clock bar CKB generated from a Phase-Locked Loop (PLL) circuit are routed to transmitter TX and receiver RX of a high-speed serial link/SerDes PHY. Due to mismatches in loading or routing parasitic, for almost all practical purposes, CK and CKB may end up having skew between them when they reach their respective target points in TX and RX. However, such skew may be detrimental to the design, and as such, a design to mitigate such skew may be beneficial. According to an embodiment, CML clock buffers 600 may be provided as shown in the FIG. 7B for the transmitter TX and FIG. 7C for the receiver RX. According to an embodiment, the CML clock buffers 600 are configured to filter out the skew between the CK and the CKB. For example, the CML clock buffers 600 could be placed locally where the complementary CK signals are needed. However, the disclosure is not limited thereto, and as such, the CML clock buffers 600 may be distributed along the entire routing from PLL to TX/RX. For example, the CML clock buffers 600 may be considered as repeaters which adjust the skew in the differential clock signal along the way.

Referring to FIG. 7B, D0 and D1 are even and odd data streams respectively. Input D for a flip-flop represents the point where the data is incident and output Q for the same represents the point where the data exits the flipflop. The driver is the final transmitter driver, which transmits the data into the channel. As shown in FIG. 7B, the even data stream D0 is input into a single flip-flop that is triggered by the adjusted clock signal CK. The odd data stream D 1 is input into a two flip-flops connected in series. The first flip-flop in the series is triggered by the adjusted clock signal CK. The second flip-flop in the series is triggered by the adjusted clock bar CKB. The flip-flops feed into a multiplexer that outputs data into the final transmitter driver.

Referring to FIG. 7C, the receiver RX includes a receiver analog front-end (RX-AFE), a decision feedback equalizer (DFE), a phase interpolator (PI) and a clock-data-recovery circuit (CDR). The receiver RX may further include a divide by 2 (DIV-by-2) circuit, which outputs CKI, CKIB, CKQ and CKQB. For example, CKI, CKIB, CKQ and CKQB are the 4 quadrature phases of a clock. Each of these 4 clocks are 90 degrees apart from each other. According to an embodiment, the DIV-by-2 circuit may generate 4 phases of quadrature clock from 2 phases of clock half-rate clock (CK and CKB). That is, the DIV-by-2 circuit may generate CKI, CKIB, CKQ and CKQB from the adjusted CK and CKB. CKI, CKIB, CKQ and CKQB may be used by the phase interpolator PI to generate an output clock signal based in a signal from the CDR. The DFE may be configured to perform equalization on signals from the AFE, using the output clock signal as a clock signal. The CDR may be configured to align the output clock signal with the received data stream (by controlling the PI).

Embodiments herein have been explained using two stages of CML buffers, however, it may be obvious to a person of ordinary skill in the art that there may be multiple CML buffers, as required, to remove skew between the complimentary clock signals (CK, CKB).

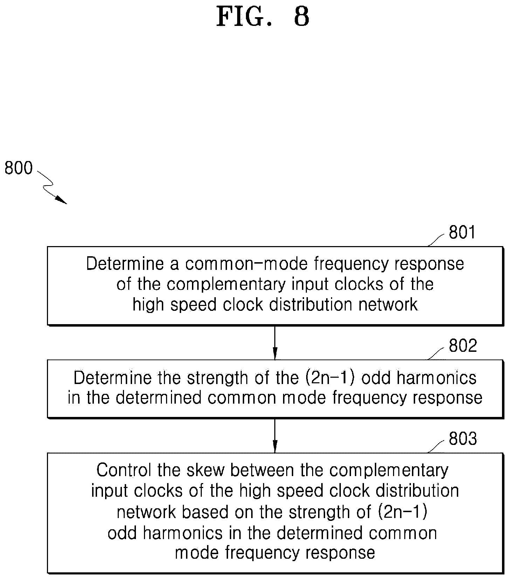

FIG. 8 illustrates a method for controlling skew between complementary input clocks of the high speed clock distribution network 600. In operation 801, the method may include determining a common-mode frequency response of complementary input clocks of a high speed clock distribution network. For example, the CML buffer 602 may determine a common-mode frequency response of the complementary input clocks of the high speed clock distribution network. In operation 802, the method may include determining a strength of the (2n-1) odd harmonics in the determined common mode frequency response. The (2n-1) odd harmonics, may comprise each odd harmonic up until the $(2n-1)^{th}$ odd harmonic, where n is the number of stages of CML buffers.

There may therefore be n total odd harmonics to be considered. For example, the CML buffer 602 may determine the strength of the (2n-1) odd harmonics in the determined common mode frequency response. According to an embodiment, the CML buffer 602 may determine the strength of the (2n-1) odd harmonics in the determined common mode frequency response similar to using Fourier Transform (FT) of the common-mode of the complementary input clocks. In operation 803, the method may include controlling a skew between the complementary input clocks of the high speed clock distribution network based on the strength of (2n-1) odd harmonics in the determined common mode frequency response. For example, the CML buffer 602 may control the skew between the complementary input clocks of the high speed clock distribution network based on the strength of (2n-1) odd harmonics in the determined common mode frequency response. Controlling the skew may reduce the skew by suppressing strength of the (2n-1) odd harmonics of the common-mode of the complementary input clocks.

According to an embodiment, the LC-tank added in the tail current source path may be configured to respond to the CM signal by blocking the tone(s) in and around its resonating frequency. Here, the resonating frequency is designed to resonate at $(2n-1)^{th}$ harmonic of the input clock frequency, thereby blocking the undersigned odd harmonics of the complementary input clock signals which corrects the skew between them. The presented order operations 801, 802, and 803 are just for understanding purposes only, and as such, the disclosure is not limited thereto. According to another embodiment, the various actions in method 800 may be performed in the order presented, in a different order or simultaneously. Further, in some embodiments, some operations listed in FIG. 8 may be omitted and/or other operations may be added.

One or more features implemented according the embodiments of the disclosure may correct up to ±2.5ps of skew between the complimentary clock signals, which would otherwise be translated into the same amount jitter at the output of any high-speed wireline transceiver; eating up to 5% of the UI for a 20Gbps serial link. This is extremely costly for such high-speed, high-performance serial links.

One or more features implemented according the embodiments of the disclosure can save high-speed flip-flops used in wireline transceivers from timing failures due to the presence of skew between the CK and CKB.

One or more features implemented according the embodiments of the disclosure may perform common-mode signal processing.

One or more features implemented according the embodiments of the disclosure may achieve dual resonance for two CML buffers in the common-mode response, and achieve multiple resonances for multiple CML buffers in the common-mode response.

Embodiments are set out in the following Clauses:

Clause 1. A skew control circuit (600) comprising:

at least one current-mode logic (CML) buffer (601, 602, 604); and
an inductor-capacitor (LC) tank connected in series with a tail current source of the at least one CML buffer (601, 602, 604),
wherein the at least one CML buffer (601, 602, 604) is configured to filter a skew between complementary input clocks to a high-speed clock distribution network.

Clause 2. The skew control circuit (600) as claimed in Clause 1, wherein a capacitor of the LC tank is a course-tuning capacitor bank.

Clause 3. The skew control circuit (600) as claimed in Clause 1 or Clause 2, wherein the at least one CML buffer (601, 602, 604) is configured to suppress odd harmonics of the complementary input clocks to filter the skew.

Clause 4. The skew control circuit (600) as claimed in any preceding Clause,

wherein the at least one CML buffer (601, 602, 604) comprises a plurality of CML buffers, and
wherein an $n^{th}$ LC tank of an $n^{th}$ CML buffer, among the plurality of CML buffers, is tuned to resonate at an $(2n-1)^{th}$ odd harmonic of the complementary input clocks, where n is a natural number.

Clause 5. The skew control circuit (600) as claimed in any preceding Clause, wherein the at least one CML buffer (601, 602, 604) is further configured to filter the skew by suppressing odd harmonics of a common mode of the complementary input clocks to the high-speed clock distribution network.

Clause 6. The skew control circuit (600) as claimed in any preceding Clause, wherein the at least one CML buffer (601, 602, 604) comprises a plurality of cascaded CML buffers, and
wherein number of stages of the plurality of cascaded CML buffers with a respective LC tank is a natural number.

Clause 7. The skew control circuit (600) as claimed in Clause 6, wherein

a first capacitance value of a first capacitor (C1) of a first LC tank in a first CML buffer from the plurality of cascaded CML buffers is tuned to have a same calibration as a phase-locked loop inductor-capacitor voltage controlled oscillator

(PLL LC-VCO) in the high-speed clock distribution network; and
a second capacitance value of a second capacitor ($C_2$) of a second LC tank in a subsequent CML buffer among the plurality of cascaded CML buffers is scaled from the first capacitance value of the first capacitor (C1) of the first LC tank in the first CML buffer,
wherein the second capacitance value of the second capacitor ($C_2$) is calibrated using the same calibration scheme as the PLL LC-VCO.

Clause 8. A method for controlling skew, the method comprising:
determining, by a current-mode logic (CML) buffer (601, 602, 604), a common-mode frequency response of a complementary input clocks of a high speed clock distribution network; and
controlling, by the CML buffer (601, 602, 604), the skew between the complementary input clocks of the high speed clock distribution network based on strength of the $(2n-1)^{th}$ odd harmonics in the determined common mode frequency response.

Clause 9. The method as claimed in Clause 8, further comprising:
determining the strength of the (2n-1) odd harmonics in the determined common mode frequency response using Fourier Transform (FT) of the common-mode of the complementary input clocks.

Clause 10. The method as claimed in Clause 8 or Clause 9, further comprising:
reducing the skew by suppressing the (2n-1) odd harmonics of the common-mode of the complementary input clocks.

Clause 11. The method as claimed in Clause 10, further comprising:
reducing the skew using an inductor-capacitor (LC) tank connected in series with a tail current source path of the CML buffer (601, 602, 604).

Clause 12. The method, as claimed in Clause 11, further comprising:
tuning an $n^{th}$ LC tank of an $n^{th}$ CML buffer, among a plurality of CML buffers include the CML buffer, to resonate at a $(2n-1)^{th}$ harmonic of the complementary input clocks.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of embodiments and examples, those skilled in the art will recognize that the embodiments and examples disclosed herein can be practiced with modification within the scope of the embodiments as described herein.

**Claims**

1. A skew control circuit (600) comprising:

   at least one current-mode logic, CML, buffer (601, 604); and
   an inductor-capacitor, LC, tank connected in series with a tail current source of the at least one CML buffer (601, 604),
   wherein the at least one CML buffer (601, 604) is configured to filter a skew between complementary input clocks to a high-speed clock distribution network.

2. The skew control circuit (600) as claimed in claim 1, wherein a capacitor of the LC tank is a course-tuning capacitor bank.

3. The skew control circuit (600) as claimed in claim 1 or claim 2, wherein the at least one CML buffer (601, 604) is configured to suppress one or more odd harmonics of the complementary input clocks to filter the skew.

4. The skew control circuit (600) as claimed in any preceding claim,

   wherein the at least one CML buffer (601, 604) comprises a plurality of CML buffers, and
   wherein an $n^{th}$ LC tank of an $n^{th}$ CML buffer, among the plurality of CML buffers, is tuned to resonate at an $(2n-1)^{th}$ odd harmonic of the complementary input clocks, where n is a natural number.

5. The skew control circuit (600) as claimed in any preceding claim, wherein the at least one CML buffer (601, 604) is further configured to filter the skew by suppressing one or more odd harmonics of a common mode of the complementary input clocks to the high-speed clock distribution network.

6. The skew control circuit (600) as claimed in any preceding claim, wherein the at least one CML buffer (601, 604) comprises a plurality of cascaded CML buffers, and
   wherein number of stages of the plurality of cascaded CML buffers with a respective LC tank is a natural number.

7. The skew control circuit (600) as claimed in claim 6, wherein

   a first capacitance value of a first capacitor ($C_1$) of a first LC tank for a first CML buffer from the plurality of cascaded CML buffers is tuned to have a same calibration as a phase-locked loop inductor-capacitor voltage controlled oscillator, PLL LC-VCO, in the high-speed clock distribution network; and
   a second capacitance value of a second capacitor ($C_2$) of a second LC tank for a subsequent CML buffer among the plurality of cascaded CML buffers is scaled from the first capacitance value of the first capacitor ($C_1$) of the first LC tank in the first CML buffer,
   wherein the second capacitance value of the second capacitor ($C_2$) is calibrated using the same calibration scheme as the PLL LC-VCO.

8. A method for controlling skew, the method comprising:

   determining, by a current-mode logic, CML, buffer (601, 604), a common-mode frequency response of complementary input clocks of a high speed clock distribution network; and
   controlling, by the CML buffer (601, 604), the skew between the complementary input clocks of the high speed clock distribution network based on strength of the $(2n-1)^{th}$ odd harmonics in the determined common mode frequency response.

9. The method as claimed in claim 8, further comprising: determining the strength of the $(2n-1)^{th}$ odd harmonics in the determined common mode frequency response using a Fourier Transform of the common-mode of the complementary input clocks.

10. The method as claimed in claim 8 or claim 9, further comprising: reducing the skew by suppressing the $(2n-1)^{th}$ odd harmonics of the common-mode of the complementary input clocks.

11. The method as claimed in claim 10, further comprising:
    reducing the skew using an inductor-capacitor, LC, tank connected in series with a tail current source path of the CML buffer (601, 604).

12. The method, as claimed in claim 11, further comprising:
    tuning an $n^{th}$ LC tank of an $n^{th}$ CML buffer, among a plurality of CML buffers that includes the CML buffer, to resonate at a $(2n-1)^{th}$ harmonic of the complementary input clocks.

# FIG. 1

# FIG. 2

EP 4 708 695 A1

# FIG. 3

# FIG. 4A

# FIG. 4B

# FIG. 5A

EP 4 708 695 A1

## FIG. 5B

CM spectrum(dB)

0.0GHz −9.15.2mdB

11.67GHz −29.64dB

35.01GHz −31.67dB

(GHz)

# FIG. 5C

11.67GHz −8.677dB

35.01GHz −20.8dB

58.35GHz −30.63dB

DM spectrum(dB)

(GHz)

EP 4 708 695 A1

FIG. 5D

EP 4 708 695 A1

FIG. 5E

EP 4 708 695 A1

FIG. 5F

FIG. 6

# FIG. 7A

```
┌─────────────┐
│     PLL     │
└─────────────┘
       │
   ┌───────────┐
  ┌┴──────────┐│
 ┌┴───────────┤│
 │ Transmitter├┘
 └────────────┘
       │
    Channel
       │
  ┌───────────┐
 ┌┴──────────┐│
┌┴───────────┤│
│  Receiver  ├┘
└────────────┘
```

# FIG. 7B

EP 4 708 695 A1

# FIG. 7C

EP 4 708 695 A1

# FIG. 8

800

801

Determine a common-mode frequency response
of the complementary input clocks of the
high speed clock distribution network

802

Determine the strength of the (2n-1) odd harmonics
in the determined common mode frequency response

803

Control the skew between the complementary
input clocks of the high speed clock distribution
network based on the strength of (2n-1)
odd harmonics in the determined common
mode frequency response

Europäisches
Patentamt

European
Patent Office

Office européen
des brevets

## EUROPEAN SEARCH REPORT

**Application Number**

EP 24 21 9417

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/121004 A1 (CHANG YI CHENG [US]) 17 May 2012 (2012-05-17) <br> * paragraphs [0003], [0004] * <br> * paragraph [0014] * <br> * paragraphs [0028] - [0030], [0036]; figure 3 * <br> * paragraphs [0031], [0032]; figure 4 * | 1-12 | INV. <br> H03K19/0185 <br> H03K19/094 |
| A | US 2004/239369 A1 (HSU LOUIS L [US] ET AL) 2 December 2004 (2004-12-02) <br> * paragraphs [0029] - [0033]; figure 1 * | 1-12 | |
| A | YUNFANG ZHOU ET AL: "Design of low phase noise LC VCO for UHF RFID reader", COMMUNICATIONS, 2009. APCC 2009. 15TH ASIA-PACIFIC CONFERENCE ON, IEEE, PISCATAWAY, NJ, USA, 8 October 2009 (2009-10-08), pages 414-417, XP031597439, ISBN: 978-1-4244-4784-8 <br> * Section II. B.; figure 2 * | 1,8 | |

**TECHNICAL FIELDS SEARCHED (IPC)**

H03K
H03F
G06F
H04L

The present search report has been drawn up for all claims

| Place of search | Date of completion of the search | Examiner |
|---|---|---|
| Munich | 26 May 2025 | Martínez Martínez, J |

EPO FORM 1503 03.82 (P04C01)

## ANNEX TO THE EUROPEAN SEARCH REPORT
## ON EUROPEAN PATENT APPLICATION NO.

EP 24 21 9417

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2025

| Patent document cited in search report | Publication date | Patent family member(s) | Publication date |
|---|---|---|---|
| US 2012121004 A1 | 17-05-2012 | CN 102469054 A | 23-05-2012 |
| | | EP 2456070 A1 | 23-05-2012 |
| | | KR 20120053466 A | 25-05-2012 |
| | | US 2012121004 A1 | 17-05-2012 |
| US 2004239369 A1 | 02-12-2004 | NONE | |

EPO FORM P0459

For more details about this annex : see Official Journal of the European Patent Office, No. 12/82